# EUROPÄISCHE PATENTSCHRIFT

(11) **EP 2 312 755 B1**
(45) Veröffentlichungstag und Bekanntmachung des Hinweises auf die Patenterteilung: **28.12.2011**
(21) Anmeldenummer: 09012876.0
(22) Anmeldetag: 12.10.2009
(51) Int. Cl.: H03L 7/099, H03K 3/03

(54) **Oszillator und Verfahren zum Erzeugen elektrischer Schwingungen**
Oscillator and method for generating electrical vibrations
Oscillateur et procédé de production d'oscillations électriques

(43) Veröffentlichungstag der Anmeldung: 20.04.2011
(73) Patentinhaber: Fraunhofer-Gesellschaft zur Förderung der angewandten Forschung e.V., 80686 München (DE)
(72) Erfinder: Völker, Matthias, 90768 Fürth (DE); Neubauer, Harald, 91052 Erlangen (DE)
(74) Vertreter: Burger, Markus

(56) Entgegenhaltungen:
- EP-A- 0 689 288
- US-A- 5 629 650
- US-A- 5 687 201
- US-A- 5 880 579
- US-A1- 2008 042 758

## Beschreibung

### Hintergrund der Erfindung

Die vorliegende Erfindung bezieht sich auf einen elektrischen Oszillator und ein Verfahren zum Erzeugen elektrischer Schwingungen, welche beispielsweise in Phasengerasteten Schleifen ("Phase Locked Loops" bzw. PLL) verwendet werden kann.

Spannungs- und stromgesteuerte Oszillatoren finden in verschiedenen Schaltungen Anwendung. Diese Oszillatoren werden z.B. in Phasengerasteten Schleifen (PLL), Verzögerungsgerasteten Schleifen ("Delay Locked Loops" bzw. DLL) und in oszillatorbasierten Analog-Digital-Wandlern (ADCs) verwendet. Für die Anwendung ist ein möglichst linearer Zusammenhang zwischen dem Steuersignal (Strom oder Spannung) des Oszillators und der Oszillationsfrequenz der von dem Oszillator erzeugten elektrischen Schwingungen wichtig.

Ein elektrischer Oszillator besteht beispielsweise aus einem Ring von Verzögerungselementen, wobei der Ausgang eines Verzögerungselementes mit dem Eingang eines nachfolgenden Verzögerungselementes verbunden ist und mindestens einer der Ausgänge eines der Verzögerungselemente als Ausgang für den Oszillator benutzt wird. Die Einstellung der Oszillationsfrequenz erfolgt bisher über Widerstands- oder Kapazitätsänderungen, beispielsweise durch Transistorenin den verwendeten Verzögerungselementen. Eine Verzögerungszeit wird dann beispielsweise durch das Laden einer Kapazität erreicht. Da diese Elemente nicht linear sind, ergibt sich ein nichtlinearer Zusammenhang zwischen der Steuergröße (Steuersignal - Strom oder Spannung) und der Oszillationsfrequenz. Die Nichtlinearität des Oszillators muss in der Anwendung speziell berücksichtigt werden.

Eine Möglichkeit ist, dass die Regelstrecke um den Oszillator (z.B. in einer PLL) so robust ausgelegt wird, dass trotz der Nichtlinearitäten die Stabilität immer gegeben ist. Bei oszillatorbasierten ADCs wird versucht, die Nichtlinearität durch eine Rückkopplung zu dämpfen (z.B. in Delta-Sigma ADCs) oder durch Vorverzerrung des Steuersignals oder Entzerrung des Ausgangssignals zu kompensieren.

Zusammenfassend lässt sich sagen, dass durch die Nichtlinearität der verwendeten Verzögerungselemente ein immenser Zusatzaufwand zur Kompensation der Nichtlinearitäten entsteht. Diese Kompensation kann durch zusätzliche Hardware oder auch durch Softwareanpassungen geschehen. Hierbei entstehen sowohl bei der Hardware-Kompensation der Nichtlinearitäten als auch bei der Software-Kompensation der Nichtlinearitäten zusätzliche Kosten.

Die US5880579 zeigt einen Versorgungsspanungsregulator für einen Spannungsgesteuerten Oszillator für PLLs. Der Versorgungsspanungsregulator weißt einen Steuerspannungseingang, einen ersten und einen zweiten Versorgungsspannungseingang, einen regulierten Spannungsausgang, eine Stromquelle und einen Verstärker auf. Die Stromquelle ist zwischen dem ersten Versorgungsspannungseingang und dem regulierten Versorgungsspannungsausgang gekoppelt und hat einen Vorspannungseingang ("Bias Input"). Der Verstärker hat einen Verstärkereingang, welcher mit dem Steuerspannungseingang gekoppelt ist, einen Verstärkerausgang, welcher mit dem Vorspannungseingang gekoppelt ist und einen Rückführungseingang ("Feedback Input"), welcher mit dem regulierten Spannungsausgang gekoppelt ist.

Die Aufgabe der vorliegenden Erfindung ist, ein Konzept zum Erzeugen elektrischer Schwingungen zu schaffen, bei dem ein möglichst linearer Zusammenhang zwischen dem Steuersignal (Strom oder Spannung) und der Oszillationsfrequenz der vom Oszillator erzeugten elektrischen Schwingungen besteht.

### Zusammenfassung der Erfindung

Diese Aufgabe wird durch einen Oszillator gemäß Anspruch 1 und ein Verfahren zum Erzeugen von elektrischen Schwingungen gemäß Anspruch 15 gelöst.

Die vorliegende Erfindung schafft einen Oszillator zur Erzeugung von elektrischen Schwingungen mit einer Umladeoszillatorschaltung zum Erzeugen der elektrischen Schwingungen und einer Regelschleife, wobei die Regelschleife ausgelegt ist, um die Umladeoszillatorschaltung so anzusteuern, dass die Stromaufnahme eines frequenzbestimmenden Teils der Umladeoszillatorschaltung einen durch ein Frequenzsteuersignal vorgegebenen Wert annimmt. Im Folgenden wird das "Frequenzsteuersignal" auch kurz als "Steuersignal" oder als "Steuergröße" bezeichnet.

Es ist der Kerngedanke der vorliegenden Erfindung, dass frequenzbestimmende Verzögerungen in der elektrischen Umladeoszillatorschaltung durch Umladevorgänge von Kapazitäten verursacht werden, und dass durch eine Regelung der Stromaufnahme einer frequenzbestimmenden Teilschaltung der Umladeoszillatorschaltung die Frequenz der von der Umladeoszillatorschaltung erzeugten Schwingung mit hoher Linearität einstellbar ist. Die Zeit, die für die Umladung einer Kapazität der Umladeoszillatorschaltung benötigt wird, hängt von der Kapazität, dem Umladestrom und dem zu erreichenden Spannungshub ab. Bei konstanter Versorgungsspannung an einem Oszillator ist der Spannungshub (bzw. Signalhub) vorgegeben. Es wurde erkannt, dass ein linearer Zusammenhang zwischen der Steuergröße und der Frequenz des Oszillators erreicht werden kann, indem die Stromaufnahme des Oszillators, bzw. zumindest einer frequenzbestimmenden Teilschaltung der Umladeoszillatorschaltung, mit einer Regelschleife der Steuergröße angepasst wird. Ein Vorteil der vorliegenden Erfindung ist somit, dass der Zusammenhang zwischen Verzögerung der Oszillatorelemente der Umladeoszillatorschaltung und dem Versorgungsstrom (bzw. der Stromaufnahme der frequenzbestimmenden Teilschaltung der Umladeoszillatorschaltung) nur konstante Parameter enthält, wodurch eine hohe Linearität erreicht werden kann. Dies ermöglicht den vereinfachten Aufbau von Oszillator-basierten ADCs, PLLs und anderen Schaltungsblöcken mit steuerbaren Oszillatoren. Oszillator-basierte ADCs mit dieser Technik können eine höhere Gesamtlinearität erreichen.

### Figurenkurzbeschreibung

Bevorzugte Ausführungsbeispiele der vorliegenden Erfindung sind nachfolgend Bezug nehmend auf die beiliegenden Zeichnungen näher erläutert. Es zeigen:
- Fig. 1: ein Blockschaltbild eines Oszillators zur Erzeugung elektrischer Schwin- gungen gemäß einem ersten Ausführungsbeispiel der vorliegenden Erfin- dung;
- Fig. 2: ein Blockschaltbild einer Umladeoszillatorschaltung zur Verwendung in einem Oszillator gemäß dem ersten Ausführungsbeispiel der vorliegenden Erfindung;
- Fig.3: ein Schaltbild eines Verzögerungselementes zur Verwendung in Oszillato- ren gemäß Ausführungsbeispielen der vorliegenden Erfindung;
- Fig. 4a: ein Diagramm zur Darstellung eines Zusammenhangs zwischen der Strom- aufnahme einer Verzögerungsteilschaltung des in Fig.3 gezeigten Verzöge- rungselementes und der Verzögerungszeit des in Fig.3 gezeigten Verzöge- rungselementes;
- Fig. 4b: ein Diagramm zur Darstellung eines Zusammenhangs zwischen der Strom- aufnahme einer frequenzbestimmenden Teilschaltung der in Fig.2 gezeigten Umladeoszillatorschaltung und der vom Oszillator erzeugten Frequenz der elektrischen Schwingungen;
- Fig. 5: ein Blockschaltbild eines Oszillators gemäß einem zweiten Ausführungsbei- spiel der vorliegenden Erfindung; und
- Fig. 6: ein Blockschaltbild eines Oszillators gemäß einem dritten Ausführungsbei- spiel der vorliegenden Erfindung.

### Detaillierte Beschreibung der Ausführungsbeispiele

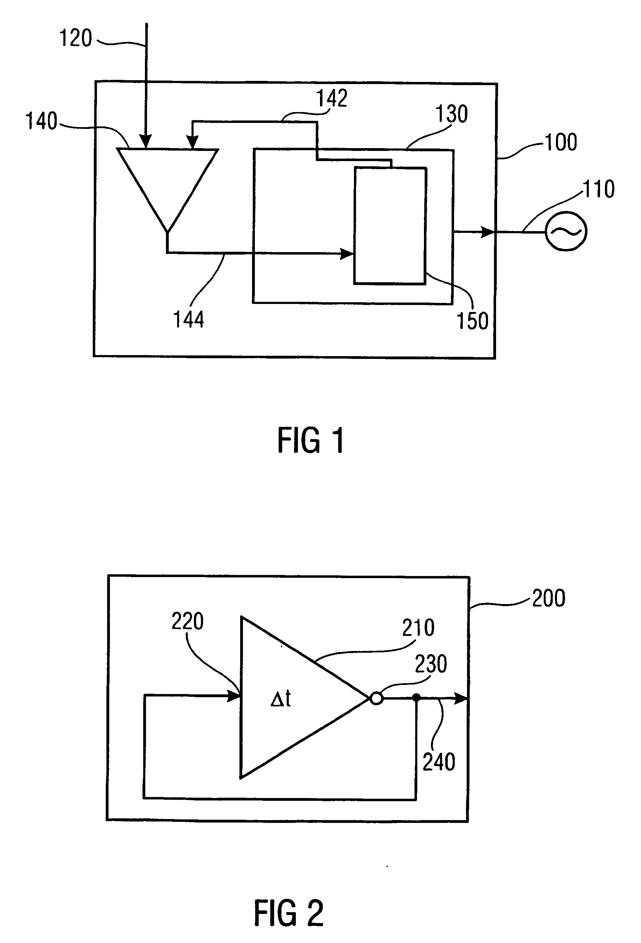

Bezug nehmend auf die Figuren 1 bis 6 werden nun verschiedene Ausführungsbeispiele der vorliegenden Erfindung erläutert.

Fig. 1 zeigt einen Oszillator 100 gemäß einem ersten Ausführungsbeispiel der vorliegenden Erfindung. Der Oszillator 100 umfasst eine Umladeoszillatorschaltung 130 sowie eine Regelschleife 140, 144, 150, 142. Der Oszillator 100 ist ausgelegt, um ein Frequenzsteuersignal 120 als Eingangsgröße zu empfangen und ein elektrisches Schwingungssignal 110 als Ausgangsgröße bereitzustellen. Die Umladeoszillatorschaltung 130 weißt eine frequenzbestimmende Teilschaltung 150 auf. Die Regelschleife 140 ist ausgelegt um, als Eingangsgröße das Frequenzsteuersignal 120 sowie ein Messsignal 142, dass die Stromaufnahme der frequenzbestimmenden Teilschaltung 150 der Umladeoszillatorschaltung 130 beschreibt, zu empfangen. Als Ausgangsinformation liefert die Regelschleife 140 eine Regelgröße 144, welche auf die frequenzbestimmende Teilschaltung 150 der Umladeoszillatorschaltung 130 wirkt. Die Umladeoszillatorschaltung 130 liefert als Ausgangssignal das elektrische Schwingungssignal 110.

Basierend auf der strukturellen Beschreibung wird nun die Funktion des ersten Ausführungsbeispiels beschrieben. Das Frequenzsteuersignal 120 gibt dem Oszillator 100 die einzustellende Frequenz der elektrischen Schwingung 110 vor. Die Regelschleife 140 empfängt das Messsignal 142 (bzw. ein davon abgeleitetes Signal), welches die Stromaufnahme der frequenzbestimmenden Teilschaltung 150 der Umladeoszillatorschaltung 130 beschreibt und vergleicht dieses mit dem Frequenzsteuersignal 120. Aus diesem Vergleich generiert die Regelschleife 140 die Regelgröße 144 (beispielsweise einen Strom oder eine Spannung), welche die Stromaufnahme der frequenzbestimmenden Teilschaltung 150 der Umladeoszillatorschaltung 130 an das Frequenzsteuersignal 120 anpasst. Ist die Stromaufnahme der frequenzbestimmenden Teilschaltung 150 der Umladeoszillatorschaltung 130 an das Frequenzsteuersignal 120 angepasst, so erzeugt der Oszillator 100 ein elektrisches Schwingungssignal 110 mit der gewünschten Frequenz.

Die Umladeoszillatorschaltung 130 beispielsweise als eine Ringoszillatorschaltung 200, wie sie in Fig. 2 gezeigt ist, ausgelegt sein. Die in Fig. 2 gezeigte Ringoszillatorschaltung 200 umfasst ein invertierendes Verzögerungselement 210 oder eine Serienschaltung mehrerer Verzögerungselemente, wobei der Ausgang 230 des Verzögerungselementes 210 (bzw. des letzten Verzögerungselements einer Serienschaltung von Verzögerungselementen) mit dem Eingang 220 des Verzögerungselementes 210 (bzw. des ersten Verzögerungselementes einer Serienschaltung von Verzögerungselementen) verbunden ist. Außerdem ist der Ausgang 230 des Verzögerungselementes 210 mit dem Ausgang des Ringoszillators 200 verbunden.

Basierend auf der strukturellen Beschreibung wird nun die Funktion der Ringoszillatorschaltung 200 beschrieben. Das Ausgangssignal 240 des Verzögerungselementes 210 wird auf den Eingang 220 des Verzögerungselementes 210 gegeben. Dadurch erreicht das Ausgangssignal 240 des Verzögerungselementes 210 nach Ablauf der Verzögerungszeit des Verzögerungselementes 210 einen im Vergleich zu dem Anfangszustand invertierten Zustand. Dieser Vorgang wird ständig wiederholt, so dass es zu einer Oszillation kommt, wobei die Verzögerungszeit des Verzögerungselementes 210 die Frequenz des Ausgangssignals 240 des Verzögerungselementes 210 bestimmt. Da der Ausgang 230 des Verzögerungselementes 210 gleich dem Ausgang der Ringoszillatorschaltung 200 ist, kann am Ausgang 230 des Verzögerungselementes 210 die elektrische Schwingung des Oszillators abgegriffen werden. Es ist auch möglich, dass die Ringoszillatorschaltung 200 aus mehr als einem Verzögerungselement besteht, wobei ein Signal nach einem vollständigen Umlauf des Ringes verzögert und invertiert sein muss.

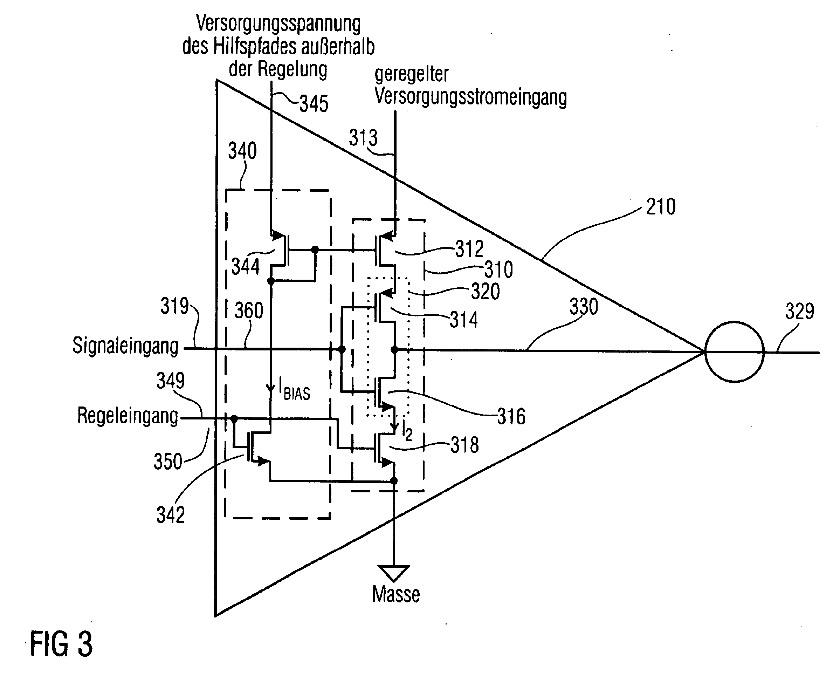

Ein beispielhaftes Verzögerungselement 210, welches in den erfindungsgemäßen Oszillatoren gemäß den Ausführungsbeispielen der Erfindung Verwendung finden kann, ist in Fig. 3 gezeigt. Im Folgenden wird die Struktur des Verzögerungselementes 210 detailliert beschrieben. Das Verzögerungselement 210 umfasst eine Verzögerungsteilschaltung 310 und eine Stromquellenteilschaltung 340. Die Stromquellenteilschaltung 340 umfasst einen ersten Stromquellentransistor 342, bei dem es sich um einen n-Kanal Feldeffektransistor ("n-Kanal FET") handelt und einen zweiten Stromquellentransistors 344, bei dem es sich um einen p-Kanal Feldeffektransistor ("p-Kanal FET") handelt. Die Verzögerungsteilschaltung 310 umfasst einen ersten Verzögerungstransistor 312, bei dem es sich um einen p-Kanal Feldeffektransistor handelt, einen zweiten Verzögerungstransitor 318, bei dem es sich um einen n-Kanal Feldeffektransistor handelt, und eine Inverterteilschaltung 320. Im folgenden wird die "Inverterteilschaltung" auch kurz als "Inverter" bezeichnet. Der Inverter 320 umfasst einen ersten Invertertransistor 314, bei dem es sich um einen p-Kanal Feldeffektransistor handelt, und einen zweiten Invertertransistor 316, bei dem es sich um einen n-Kanal Feldeffektransistor handelt. Ein Gate-Anschluss des ersten Stromquellentransistors 342 ist mit einem Regeleingang 349 des Verzögerungselementes 210 verbunden ist. Ein Drain-Anschluss des ersten Stromquellentransistors 342 ist mit einem Drain-Anschluss des zweiten Stromquellentransistors 344 verbunden. Ein Source-Anschluss des ersten Stromquellentransistors 342 ist mit Masse verbunden. Der Drain-Anschluss des zweiten Stromquellentransistors 344 ist weiterhin mit einem Gate-Anschluss des zweiten Stromquellentransistors 344 verbunden. Ein Source-Anschluss des zweiten Stromquellentransistors 344 ist mit einer Versorgungsspannungszuführung 345 verbunden. Weiterhin ist der Gate-Anschluss des zweiten Stromquellentransistors 344 mit einem Gate-Anschluss des ersten Verzögerungstransistors 312 verbunden. Ein Source-Anschluss des ersten Verzögerungstransistors 312 ist mit einem Eingang 313 für einen geregelten Versorgungsstrom verbunden. Ein Drain-Anschluss des ersten Verzögerungstransistors 312 ist mit einem Source-Anschluss des ersten Invertertransistors 314 verbunden. Ein Gate-Anschluss des ersten Invertertransistors 314 ist mit einem Signaleingang 319 des Verzögerungselementes 210, an dem das zu invertierende und zu verzögernde Signal 360 anliegt, verbunden. Weiterhin ist der Gate-Anschluss des ersten Invertertransistors 314 mit einem Gate-Anschluss des zweiten Invertertransistors 316 verbunden. Ein Drain-Anschluss des ersten Invertertransistors 314 ist mit einem Drain-Anschluss des zweiten Invertertransistors 316 verbunden. Weiterhin sind der Drain-Anschluss des ersten Invertertransistors 314 sowie der Drain-Anschluss des zweiten Invertertransistors 316 mit einem Signalausgang 329, an dem das Ausgangssignal 330 anliegt, des Verzögerungselementes 210 verbunden. Ein Source-Anschluss des zweiten Invertertransistors 316 ist mit einem Source-Anschluss des zweiten Verzögerungstransistors 318 verbunden. Ein Gate-Anschluss des zweiten Verzögerungstransistors 318 ist mit dem Gate-Anschluss des ersten Stromquellentransistors 342 verbunden. Der Source-Anschluss des zweiten Verzögerungstransistors 318 ist weiterhin mit Masse verbunden.

Basierend auf der strukturellen Beschreibung des Verzögerungselementes 210 wird nun die Funktion erklärt. Die Stromquellenteilschaltung 340 trägt dazu bei die Stromaufnahme der Verzögerungsteilschaltung 310 abhängig von der an dem Regeleingang 349 anliegenden Regelgröße 350 anzupassen. Hierbei stellt der erste Stromquellentransistor 342 abhängig von der Regelgröße 350 (Spannung) einen Arbeitspunktstrom (Biasstrom) I_{BIAS} ein. Dabei wird erreicht, dass ein durch die Drain-Sourcestrecke des zweiten Stromquellentransistors 344 fließender Strom bevorzugt genauso groß ist wie der durch die Drain-Sourcestrecke des ersten Stromquellentransistors 342 fließende Strom (zumindest aber proportional zu dem durch die Drain-Sourcestrecke des ersten Stromquellentransistors 342 fließende Strom ist). Entsprechend stellt sich an dem Gate-Anschluss des zweiten Stromquellentransistor 344 ein Potential ein, bei dem sich die genannten Verhältnisse ergeben. Der zweite Stromquellentransistor 344 bildet mit dem ersten Verzögerungstransistor 312 einen Stromspiegel, wobei davon ausgegangen wird, dass durch die Beschaltung zwischen der Versorgungsspannungszuführung 345 und dem Eingang 313 für den geregelten Versorgungsstrom sichergestellt wird, dass in einem Betrieb die Source-Potentiale des zweiten Stromquellentransistors 344 und des ersten Verzögerungstransistor 312 sich nur wenig, bevorzugt um weniger als 200mV, oder sogar um weniger als 100mV, oder noch besser um weniger als 10mV unterscheiden. Der durch den zweiten Stromquellentransistor 344 und dem ersten Verzögerungstransistor 312 gebildete Stromspiegel begrenzt einen maximalen Laststreckenstrom (Source-Drain-Strom) des ersten Invertertransistors 314, und zwar abhängig von der an dem Regeleingang 349 anliegenden Regelgröße 350. Der zweite Verzögerungstransistor 318 begrenzt abhängig von der Regelgröße 350 einen maximalen Laststreckenstrom (Drain-Source-Strom) des zweiten Invertertransistors 316. Durch die gezeigte Anordnung wird erreicht, dass eine maximaler Laststreckenstrom des ersten Invertertransistor 314 proportional zu einem maximalen Laststreckenstrom des zweiten Invertertransistors 316 einstellbar ist.

Ferner sei darauf hingewiesen, dass der Laststreckenstrom des ersten Invertertransistor 314 als Umladestrom für eine Ausgangskapazität des Inverters 320, bzw. eine an dem Inverterausgang angeschlossene Kapazität (z.B. Eingangskapazität einer nachfolgenden Stufe) wirkt, so dass die Beschränkung des Laststreckenstroms eine Beschränkung einer Geschwindigkeit, mit der eine eingangsseitig fallende Flanke an dem Eingang 319 einen Spannungsanstieg an dem Ausgang 329 des Verzögerungselementes 210 bewirkt, mit sich bringt.

In analoger Weise sei darauf hingewiesen, dass der Laststreckenstrom des zweiten Invertertransistors 316 als Umladestrom für eine Ausgangskapazität des Inverters 320, bzw. eine an dem Inverterausgang angeschlossene Kapazität (z.B. Eingangskapazität einer nachfolgenden Stufe) wirkt, so dass die Beschränkung des Laststreckenstroms eine Beschränkung einer Geschwindigkeit, mit der eine eingangsseitig steigende Flanke an dem Eingang 319 einen Spannungsabfall an dem Ausgang 329 des Verzögerungselementes 210 bewirkt, mit sich bringt.

Der erste Invertertransistor 314 ist mit dem zweiten Invertertransistor 316 so verbunden, dass sie den Inverter 320 bilden. Ein Eingangssignal 360 an diesem Inverter 320 wird invertiert am Ausgang des Inverters als Ausgangssignal 330 ausgegeben. Aufgrund der Begrenzung der Laststreckenströme der Invertertransistoren 314 und 316 entsteht aufgrund der daraus resultierenden Begrenzung des von dem Inverter 320 bereitgestellten Ausgangsstrom eine Verzögerungszeit beim Laden von Eingangskapazitäten der Transistoren einer nachfolgenden, beispielsweise gleichartig aufgebauten Stufe. Diese Verzögerungszeit steht in linearem Zusammenhang mit der (mittleren) Stromaufnahme der Verzögerungsteilschaltung 310.

Zusammenfassend lässt sich die Funktion des Verzögerungselementes 210 wie folgt beschreiben: Ein Eingangssignal 360 wird abhängig von der Regelgröße 350 verzögert und invertiert als Ausgangssignal 330 des Verzögerungselementes 210 ausgegeben.

Die in dem beispielhaften Verzögerungselement 210 verwendeten Transistoren sind in CMOS Technologie realisiert. Alternativ ist es auch möglich, andere Techniken, wie z.B. Bipolartransistoren, einzusetzen. So können beispielsweise, ein oder mehrere der gezeigten Feldeffektransistoren (FETs) durch Bipolartransistoren ersetzt werden, wobei ein n-Kanal FET durch einen npn-Bipolartransistor ersetzt werden kann, und wobei ein p-Kanal FET durch einen pnp-Bipolartransistor ersetzt werden kann.

Der Einsatz von CMOS-Verzögerungselementen hat den Vorteil, dass nahezu der gesamte Versorgungsstrom (also beispielsweise der über den geregelten Versorgungstromeingang 313 an den Inverter 320 gelieferte Strom) genutzt wird, um die Kapazitäten des nächsten Verzögerungselementes in der Kette oder dem Ring umzuladen. Bei konstanter Versorgungsspannung in einem Verzögerungselement ist der Signalhub vorgegeben (wobei von einem Stromfluss zur Arbeitspunkteinstellung, beispielsweise dem Strom durch die Drain-Source-Strecke der Stromquellentransistoren 342 und 344 abgesehen wird). Die Gesamtkapazität eines Verzögerungselementes ist, durch den Aufbau und die Spannungsabhängigkeit der Einzelkapazitäten vorgegeben. Somit ergibt sich die Verzögerungszeit des Verzögerungselementes 210 direkt aus dem Versorgungsstrom (bzw. ist zu dem Versorgungsstrom mit hoher Präzision umgekehrt proportional).

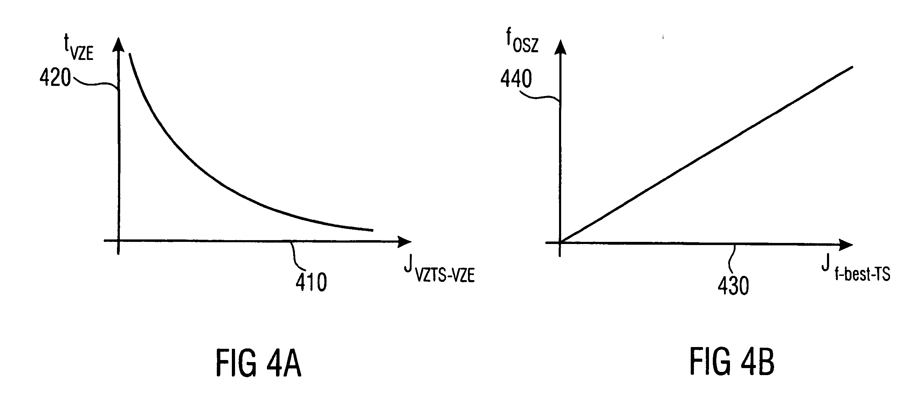

Fig. 4a zeigt einen Zusammenhang zwischen der an einer Abszisse 410 angetragenen Stromaufnahme I_{VZTS-VZE} der Verzögerungsteilschaltung 310 des Verzögerungselementes 210 und der durch das Verzögerungselement 210 erzeugten, an einer Ordinate 420 angetragenen Verzögerungszeit t_{VZE}. Deutlich zu erkennen ist hier, dass bei zunehmender Stromaufnahme I_{VZTS-VZE} der Verzögerungsteilschaltung 310 die Verzögerungszeit t_{VZE} des Verzögerungselementes 210 sinkt. Die Stromaufnahme I_{VZTS-VZE} steht in einem annähernd umgekehrt proportionalen Verhältnis zu der Verzögerungszeit t_{VZE}, wobei die Stromaufnahme I_{VZTS-VZE} den Strom beschreibt, welcher über den geregelten Versorgungstromeingang 313 an die Verzögerungsteilschaltung 310 des Verzögerungselements 210 geliefert wird und im Inverter 320 genutzt wird um die Kapazitäten des nächsten Verzögerungselements in der Kette oder dem Ring umzuladen.

Fig. 4b zeigt einen Zusammenhang zwischen der an einer Abszisse 430 angetragenen Stromaufnahme I_{f-best-TS} der frequenzbestimmenden Teilschaltung 150 der Umladeoszillatorschaltung 130 und der durch den Oszillator 100 erzeugten an einer Ordinate angetragenen Oszillationsfrequenz f_{OSZ} der elektrischen Schwingungen. Deutlich zu sehen ist hier, dass mit einer Zunahme der Stromaufnahme I_{f-best-TS} der frequenzbestimmenden Teilschaltung 150 der Umladeoszillatorschaltung 130 auch die vom Oszillator 100 erzeugte Frequenz f_{OSZ} der elektrischen Schwingungen zunimmt. Die Stromaufnahme I_{f-best-TS} steht in einem annähernd proportionalen Verhältnis zu der Oszillationsfrequenz f_{OSZ}, wobei die Stromaufnahme I_{f-best-TS} der frequenzbestimmenden Teilschaltung 150 der Umladeoszillatorschaltung 130, beispielsweise gleich der Summe der Stromaufnahmen I_{VZTS-VZE} der Verzögerungsteilschaltungen 310 aller Verzögerungselemente 210 der Umladeoszillatorschaltung 130 ist.

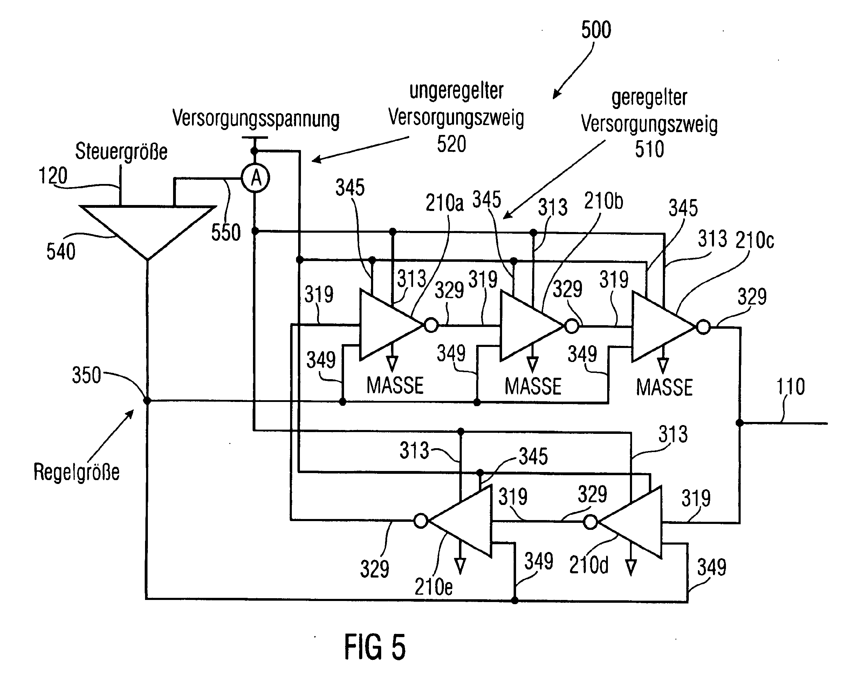

Anhand von Fig. 5 wird nun die Struktur eines Oszillators 500 gemäß einem zweiten Ausführungsbeispiel der vorliegenden Erfindung erläutert. Der Oszillator 500 verfügt über fünf (oder eine andere ungerade Zahl) Verzögerungselemente 210, wobei diese Verzögerungselemente so verschaltet sind, dass sie eine Ringoszillatorschaltung 200 bilden. Ein Signalausgang 329 eines ersten Verzögerungselementes 210a ist mit einem Signaleingang 319 eines zweiten Verzögerungselementes 210b verbunden. Ein Signalausgang 329 des zweiten Verzögerungselementes 210b ist mit einem Signaleingang 319 eines dritten Verzögerungselementes 210c verbunden. Ein Signalausgang 329 des dritten Verzögerungselementes 210c ist mit einem Signaleingang 319 eines vierten Verzögerungselementes 210d verbunden. Ein Signalausgang 329 des vierten Verzögerungselementes 210d ist mit einem Signaleingang 319 eines fünften Verzögerungselementes 210e verbunden. Ein Signalausgang 329 des fünften Verzögerungselementes 210e ist mit einem Signaleingang 319 des ersten Verzögerungselementes 210a verbunden. Der Signalausgang 110 des Oszillators 500 basiert auf dem Signalausgang 329 des dritten Verzögerungselementes 210c.

Jedes der Verzögerungselemente 210a-210e ist mit einem ungeregelten Versorgungszweig 520 des Oszillators 500 verbunden, wobei der ungeregelte Versorgungszweig 520 jeweils mit der Versorgungsspannungszuführung 345 der Stromquellenteilschaltung 340 der Verzögerungselemente 210a-210e verbunden ist. Ein geregelter Versorgungszweig 510 ist mit den Anschlüssen 313 der Verzögerungsteilschaltungen 310 der Verzögerungselemente 210a-210e verbunden. Ein Regler 540 empfängt an seinen Eingängen die Frequenzsteuergröße 120 sowie ein Messsignal 550, welches eine Gesamtstromaufnahme der Inverter 320 der Verzögerungselemente 210a-210e, bzw. allgemein die Gesamtstromaufnahme der frequenzbestimmenden Teilschaltung 150 der Ringoszillatorschaltung 200 über den geregelten Versorgungszweig 510 angibt. Das Messsignal 550 kann beispielsweise ein Mittelwert der genannten Gesamtstromaufnahme über eine Mehrzahl von Perioden des Oszillatorsignals beschreiben, bzw. eine Tiefpass-gefilterte Version der tatsächlichen Gesamtstromaufnahme darstellen. An einem Ausgang liefert der Regler 540 eine Regelgröße 350, welche auf die Regeleingänge 349 der Verzögerungselemente 210a-210e geführt ist.

Ausgehend von der strukturellen Beschreibung wird nun die Funktion des Oszillators 500 gemäß dem zweiten Ausführungsbeispiel der vorliegenden Erfindung erläutert. Der Regler 540 bildet, basierend auf der Frequenzsteuergröße 120 und dem Messsignal 550, dass die Gesamtstromaufnahme der frequenzbestimmenden Teilschaltung 150 beschreibt, eine Regelgröße 350, wobei die Gesamtstromaufnahme der frequenzbestimmenden Teilschaltung 150 des Oszillators gleich der Summe der Stromaufnahmen der Verzögerungsteilschaltungen 310 der Verzögerungselemente 210a-210e ist. Die Stromaufnahme der Stromquellenteilschaltungen 340 der Verzögerungselemente 210a-210e ist in der Gesamtstromaufnahme der frequenzbestimmenden Teilschaltung 150 nicht enthalten, bzw. wird bei der Ermittlung des Messsignals 550 nicht berücksichtigt. Die vom Regler 540 gebildete Regelgröße 350 ist so ausgelegt, dass sie die Gesamtstromaufnahme der frequenzbestimmenden Teilschaltung 150 dem Frequenzsteuersignal 120 nachführt. Da die Gesamtstromaufnahme der frequenzbestimmenden Teilschaltung 150 in direkter Abhängigkeit zu der erzeugten Oszillationsfrequenz der elektrischen Schwingungen steht, lässt sich jedem Wert der Frequenzsteuergröße 120 genau eine Oszillationsfrequenz zuordnen. Die Periodendauer der von dem Oszillator erzeugten elektrischen Schwingung ist beispielsweise, gleich dem doppelten der Verzögerungszeit der Verzögerungselemente 210a-210e, wobei die Oszillationsfrequenz gleich dem Reziproken der Periodendauer der elektrischen Schwingung ist. Da die Verzögerungszeit eines Verzögerungselementes 210 mit guter Genauigkeit umgekehrt proportional zu der Stromaufnahme der Verzögerungsteilschaltung 310 des Verzögerungselements 210 ist, folgt dass die Oszillationsfrequenz mit guter Genauigkeit proportional zu dem Frequenzsteuersignal 120 ist.

In anderen Worten zeigt Fig. 5 einen beispielhaften Aufbau eines CMOS-Ringoszillators. Dabei wird die Steuergröße 120 mit der "Gesamtstromaufnahme" verglichen. Mit Hilfe eines zusätzlichen Signals (Regelgröße 350) kann dann die "Gesamtstromaufnahme" der frequenzbestimmenden Teilschaltung 150 der Referenzgröße (Steuergröße 120) nachgeführt werden.

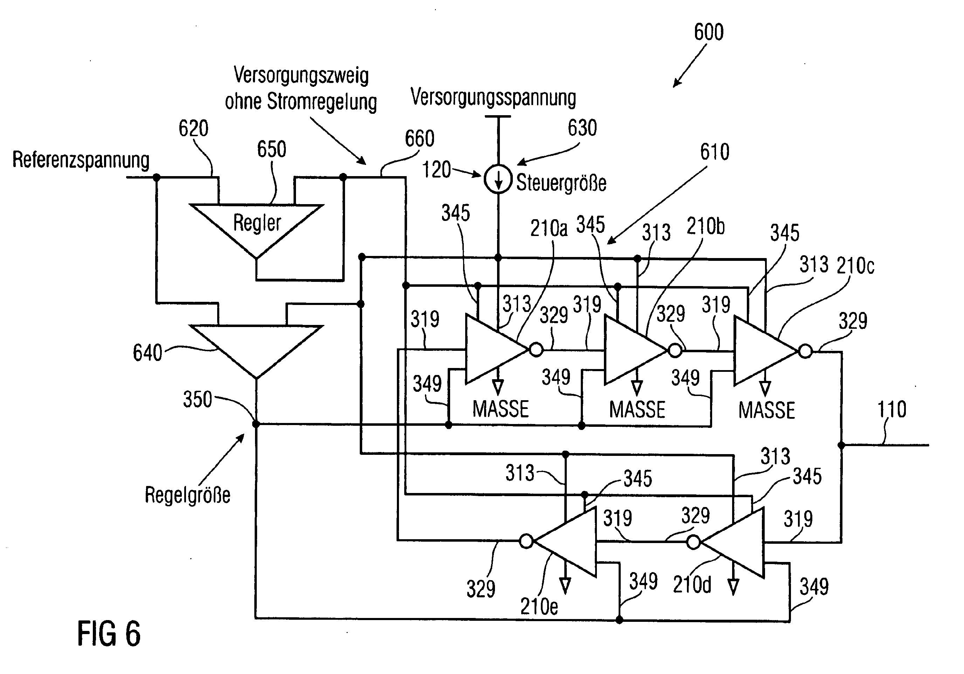

Eine alternative Implementierungsmöglichkeit ist in Fig. 6 dargestellt. Fig. 6 zeigt einen Oszillator 600 gemäß dem dritten Ausführungsbeispiel der vorliegenden Erfindung. Im Folgenden wird nun die Struktur des Oszillators 600 gemäß dem dritten Ausführungsbeispiel der vorliegenden Erfindung beschrieben. Der Oszillator 600 verfügt über fünf Verzögerungselemente 210a-210e. Ein Signalausgang 329 eines ersten Verzögerungselementes 210a ist mit einem Signaleingang 319 eines zweiten Verzögerungselementes 210b verbunden. Ein Signalausgang 329 des zweiten Verzögerungselementes 210b ist mit einem Signaleingang 319 eines dritten Verzögerungselementes 210c verbunden. Ein Signalausgang 329 des dritten Verzögerungselementes 210c ist mit einem Signaleingang 319 eines vierten Verzögerungselementes 210d verbunden. Ein Signalausgang 329 des vierten Verzögerungselementes 210d ist mit einem Signaleingang 319 eines fünften Verzögerungselementes 210e verbunden. Ein Signalausgang 329 des fünften Verzögerungselementes 210e ist mit einem Signaleingang 319 des ersten Verzögerungselementes 210a verbunden. Die Verzögerungselemente 210a-210e bilden daher eine Ringoszillatorschaltung 200. Der Ausgang 110 der Ringoszillatorschaltung 200 basiert auf dem Signalausgang 329 des dritten Verzögerungselementes 210c. Weiterhin umfasst der Oszillator 600 einen stromgesteuerten Versorgungszweig 610 und einen ungeregelten Versorgungszweig 660. Der stromgesteuerte Versorgungszweig 610 ist mit den Anschlüssen 313 der Verzögerungsteilschaltungen 310 der Verzögerungselemente 210a-210everbunden. Außerdem ist der stromgesteuerte Versorgungszweig 610 mit einem ersten Eingang eines ersten Reglers 640 verbunden. Weiterhin umfasst der Oszillator 600 eine steuerbare Stromquelle 630, welche in Abhängigkeit des Frequenzsteuersignals 120 einen einstellbaren Strom in den stromgesteuerten Versorgungszweig 610 einprägt. An einem zweiten Eingang des ersten Reglers 640, empfängt der erste Regler 640 eine Referenzspannung 620 und an einem Ausgang des ersten Reglers 640, liefert der Regler 640 eine Regelgröße 350. Die Regelgröße 350 ist mit den Regeleingängen 349 der Verzögerungselemente 210a-210e verbunden. Bei einem zweiten Regler 650 ist ein erster Eingang mit einem Ausgang des Reglers 650 gekoppelt. Weiterhin ist der erste Eingang des Reglers 650 mit dem ungeregelten Versorgungszweig 660 verbunden, wobei der ungeregelte Versorgungszweig 660 weiterhin mit den Anschlüssen 345 der Stromquellenteilschaltungen 340 der Verzögerungselemente 210a-210e verbunden ist. An einem zweiten Eingang des zweiten Reglers 650 liegt die Referenzspannung 620 an.

Ausgehend von der strukturellen Beschreibung wird nun die Funktion des Oszillators 600 gemäß dem dritten Ausführungsbeispiel der vorliegenden Erfindung beschrieben. Im Gegensatz zu dem vorherigen Ausführungsbeispiel wird bei diesem dritten Ausführungsbeispiel der Versorgungsstrom (beispielsweise der Gesamtversorgungsstrom der frequenzbestimmenden Teilschaltung 150 der Ringoszillatorschaltung 200) vorgegeben und der Regler 640 eingesetzt, um die Spannung über der Ringoszillatorschaltung 200 konstant zu halten. Das Frequenzsteuersignal 120 bestimmt den Strom, welcher von der steuerbaren Stromquelle 630 in den stromgesteuerten Versorgungszweig 610 eingeprägt wird. Der Regler 640 vergleicht, bevorzugt kontinuierlich, die Referenzspannung 620 mit der Versorgungsspannung der frequenzbestimmenden Teilschaltung 150 der Ringoszillatorschaltung 200, wobei die Versorgungsspannung der frequenzbestimmenden Teilschaltung 150 über dem stromgesteuerten Versorgungszweig 610 liegt und die Versorgungsspannung für die Verzögerungsteilschaltungen 310 der Verzögerungselemente 210a-210e darstellt. Bei Veränderung der Versorgungsspannung über dem stromgesteuerten Versorgungszweig 610 kann der erste Regler 640 mit Hilfe der Regelgröße 350 die Gesamtstromaufnahme der frequenzbestimmenden Teilschaltung 150 der Ringoszillatorschaltung 200 regeln, beispielsweise durch Vergrößern oder Verkleinern der elektrischen Spannung der Regelgröße 350. Sinkt beispielsweise die Versorgungsspannung über dem stromgesteuerten Versorgungszweig 610, so ist das ein Zeichen, dass die frequenzbestimmende Teilschaltung 150 mehr Strom aus der steuerbaren Stromquelle 630 zieht, als von dem Frequenzsteuersignal 120 vorgegeben. In diesem Fall muss der erste Regler 640 eingreifen, indem er die Gesamtstromaufnahme der frequenzbestimmenden Teilschaltung 150 durch Verändern der Regelgröße 350 (beispielsweise Senken der Spannung der Regelgröße 350) senkt.

Ist die Versorgungsspannung über dem stromgesteuerten Versorgungszweig 610 konstant, beispielsweise gleich der Referenzspannung 620, so ist die durch den Oszillator 600 erzeugte Oszillationsfrequenz gleich der durch die Stellgröße 120 gewünschten Frequenz. Weiterhin sei zu erwähnen, dass bei konstanter Versorgungsspannung über dem stromgesteuerten Versorgungszweig 610 gewährleistet ist, dass die Schwingungsamplitude der von dem Oszillator 600 erzeugten elektrischen Schwingungen konstant ist.

Elektrische Schwingungen entstehen auch hier, wie bei dem vorherigen Ausführungsbeispiel durch eine ungerade Anzahl von Verzögerungs- und Invertierungsschritten eines Signals.

Wie in dem zweiten und dem dritten Ausführungsbeispiel gezeigt, kann der Oszillatorring zusätzlich auch ungeregelte Elemente und weitere Strompfade innerhalb der geregelten Verzögerungselemente enthalten. Wenn die Stromaufnahme der zusätzlichen Elemente oder Pfade konstant oder linear zur Frequenz ist, können diese gemeinsam mit dem Ring (beispielsweise mit der Ringoszillatorschaltung 200) versorgt werden. Alternativ muss eine Stromversorgung außerhalb der Regelung vorgesehen werden. Ein solcher Pfad ist in den Fig. 5 und 6 in Form eines Stromspiegels (wie er beispielsweise gemäß Figur 3 mit den Transistoren 344 und 312 realisiert ist) dargestellt. Mit anderen Worten umfassen die Oszillatoren 500 und 600 ungeregelte Versorgungszweige 520 und 660.

Der zweite Regler 650 des Oszillators 600 stellt sicher, dass die "ungeregelten Elemente und weitere Strompfade" über den ungeregelten Versorgungszweig 660 eine Versorgungsspannung bekommen, die der Versorgungsspannung der frequenzbestimmenden Teilschaltung 150 des Ringoszillators 200 entspricht. Somit wird beispielsweise sichergestellt, dass an dem Anschluss 345 und dem Anschluss 313 der Verzögerungselemente 210a-210e annäherungsweise gleiche Potentiale anliegen, was beispielsweise für die Funktion des Stromspiegels (gebildet aus den Transistoren 344 und 312) wichtig ist.

Die Oszillatoren 500 und 600 können eine beliebige Anzahl von Verzögerungselementen enthalten, unter der Bedingung, dass das Signal nach einem vollständigen Umlauf invertiert ist. Die Ringoszillatorschaltung 200 kann einen oder mehrere Ausgänge haben. Die Verzögerungselemente des Oszillators können auch differentiell ausgelegt sein.

Weiterhin ist es möglich, dass die Verzögerungselemente 210a-210e Arbeitpunkteinstellungsteilschaltungen aufweisen, die dazu dienen, um Transistoren in ihrem Arbeitspunkt zu betreiben, wobei Arbeitpunkteinstellungsteilschaltungen keinen Einfluss auf die Regelung nehmen.

Weiterhin ist es möglich, dass die Regelschleife eines Oszillators eine Mehrzahl von Teilregelschleifen umfasst, wobei jeder Teilregelschleife genau ein Verzögerungselement des Oszillators zugeordnet ist.

Ein auf der vorliegenden Erfindung basierender Oszillator kann in verschiedenen technischen Anwendungsgebieten eingesetzt werden, wie z.B. Analog/Digital-Umsetzer mit Oszillatoren (Nyquist-Converter und Delta/Sigma-Modulatoren), Phase-Locked-Loops oder Delay-Locked-Loops.

Zusammenfassend lässt sich sagen, da der Zusammenhang zwischen Verzögerung der Oszillatorelemente und Versorgungsstrom nur konstante Parameter enthält, kann eine hohe Linearität bei CMOS-basierten Verzögerungselementen erreicht werden, dies ermöglicht den vereinfachten Aufbau von Oszillator-basierten ADCs, PLLs und anderen Schaltungsblöcken mit steuerbaren Oszillatoren. Weiterhin können Oszillator-basierte ADCs mit dieser Technik eine höhere Gesamtlinearität erreichen.

Ein Verfahren zur Erzeugung von elektrischen Schwingungen gemäß der vorliegenden Erfindung erzeugt eine elektrische Schwingung durch periodisches Umladen eines Schaltungsknoten unter Verwendung eines Umladestroms. Das Verfahren kann um alle Aspekte und Funktionalitäten der erfindunsgemäßen Vorrichtungen ergänzt werden.

## Patentansprüche

1. Oszillator (100; 500; 600) zum Erzeugen von elektrischen Schwingungen (110) in Abhängigkeit von einem Frequenzsteuersignal (120), wobei der Oszillator (100) folgende Merkmale aufweist:
eine Umladeoszillatorschaltung (130; 210a-210e) zum Erzeugen der elektrischen Schwingungen (110) mit zumindest einer Stromquellenteilschaltung (340, 342, 344) und zumindest einer frequenzbestimmenden Teilschaltung (150; 312, 314, 316, 318);
eine Regelschleife (140, 144, 150, 142; 540, 640, 350, 349, 210a-210e, 313), die ausgelegt ist, um die Umladeoszillatorschaltung (130; 210a-210e) so anzusteuern, dass die Stromaufnahme der frequenzbestimmenden Teilschaltung (150; 312, 314, 316, 318) der Umladeoszillatorschaltung (130; 210a-210e) einen durch das Frequenzsteuersignal (120) vorgegebenen Wert annimmt; und
einen geregelten Versorgungszweig (510; 610) in dem die Regelschleife (140, 144, 150, 142; 540, 640, 350, 349, 210a-210e, 313) zwischen einen Regeleingang (349) der Umladeoszillatorschaltung (130; 210a-210e) und einen geregelten Versorgungsstromeingang (313) der frequenzbestimmenden Teilschaltung (150; 312, 314, 316, 318) geschaltet ist.

2. Oszillator (100; 500; 600) gemäß Anspruch 1, ferner aufweisend einen ungeregelten Versorgungszweig (520, 660) welcher ausgebildet ist, um die zumindest eine Stromquellenteilschaltung (340, 342, 344) mit einer Versorgungspannung zu versorgen.

3. Oszillator (100; 500; 600) gemäß Anspruch 1 oder 2,
bei dem die Umladeoszillatorschaltung (130; 210a-210e) als eine Ringoszillatorschaltung (200) ausgelegt ist;
wobei die Ringoszillatorschaltung (200) mindestens ein Verzögerungselement (210; 210a-210e) umfasst; und
wobei das zumindest eine Verzögerungselement (210; 210a-210e) ausgelegt ist, um ein Eingangssignal (220, 360) zu empfangen und ein Ausgangssignal (240; 330) bereitzustellen, das auf dem Eingangssignal (220, 360) basiert und in dem Flanken gegenüber zugehörigen Flanken des Eingangssignals (240, 330) zeitlich verzögert sind.

4. Oszillator (100; 500; 600) gemäß Anspruch 3,
bei dem die Ringoszillatorschaltung (200; 210a-210e) eine Mehrzahl von Verzögerungselementen (210; 210a, 210a-210e) umfasst,
wobei die Mehrzahl der Verzögerungselemente (210; 210a-210e) so verbunden sind, dass sie einen Ring bilden und ein Signal an einem Eingang eines vorbestimmten Verzögerungselementes (210c) der Verzögerungselemente (210; 210a, 210b, 210c, 210d, 210e) nach einem vollständigen Umlauf durch den Ring im Vergleich zu einem vorherigen Zustand invertiert ist;
wobei die Ringoszillatorschaltung (200) so ausgelegt ist, dass ein Ausgangssignal (110) der Ringoszillatorschaltung (200) auf dem Ausgangssignal (329) eines Verzögerungselementes (210; 210c) der Verzögerungselemente (210; 210a-210e) basiert.

5. Oszillator (100; 500; 600) gemäß einem der Ansprüche 3 oder 4,
bei dem die zumindest eine frequenzbestimmende Teilschaltung (150; 312, 314, 316, 318) eine Verzögerungsteilschaltung (310; 312, 314, 316, 318) des zumindest einem Verzögerungselementes (210) umfasst;
wobei die Verzögerungsteilschaltung (310) des Verzögerungselementes (210) so ausgelegt ist, dass ein Zusammenhang zwischen der Stromaufnahme (I_{VZTS-VZE}) der Verzögerungsteilschaltung (310; 312, 314, 316, 318) des Verzögerungselementes (210) und einer durch die Verzögerungsteilschaltung (310; 312, 314, 316, 318) des Verzögerungselementes (210) erzeugten Verzögerungszeit (T_{VZE}) besteht;
wobei die Ringoszillatorschaltung (200) so ausgelegt ist, dass die durch die, Verzögerungsteilschaltung (310; 312, 314, 316, 318) des Verzögerungselementes (210) erzeugte Verzögerungszeit (t_{VZE}) umgekehrt proportional zu einer Frequenz (f_{OSZ}) der durch den Oszillator (100; 500; 600) erzeugten elektrischen Schwingungen (110) ist.

6. Oszillator (100; 500; 600) gemäß Anspruch 5,
bei dem die Verzögerungsteilschaltung (310; 312, 314, 316, 318) des zumindest einen Verzögerungselementes (210) einen Inverter (320; 314, 316) mit einstellbarem maximalen Ausgangsstrom umfasst, wobei der Inverter (320; 314, 316) ausgelegt ist, um das Eingangssignal (360) des Verzögerungselementes (210) zu invertieren und wobei der maximale Ausgangsstrom des Inverters (320; 314, 316) die frequenzbestimmenden Teilschaltung (150; 312, 314, 316, 318) beeinflusst.

7. Oszillator (100; 500; 600) gemäß einem der Ansprüche 5 oder 6,
bei dem das zumindest eine Verzögerungselement (210) in CMOS-Technologie realisiert ist;
wobei ein Ausgang eines vorgegebenen Verzögerungselementes (210; 210a) mit einem Eingang eines in einem Oszillatorring der Ringoszillatorschaltung (200) nachfolgenden Verzögerungselemente (210; 210b) gekoppelt ist, um eine Eingangskapazität des nachfolgenden Verzögerungselementes (210b) unter Verwendung der Verzögerungsteilschaltung (310; 312, 314, 316, 318) des vorgegebenen Verzögerungselementes (210; 210a), umzuladen,
so dass eine Verzögerungszeit bei der Ausbreitung einer Signalflanke zu dem nachfolgenden Verzögerungselement (210; 210b) durch eine Umladezeit der Eingangskapazität des nachfolgenden Verzögerungselementes (210; 210b) beeinflusst wird; und
wobei das vorgegebene Verzögerungselement (210; 210a) so ausgelegt ist, dass der zum Umladen der Eingangskapazität des nachfolgenden Verzögerungselementes (210; 210b) bereitgestellte Strom in einem vorgegebenen Zusammenhang mit der Stromaufnahme der Verzögerungsteilschaltung (310; 312, 314, 316, 318) des vorgegebenen Verzögerungselementes (210; 210a) steht.

8. Oszillator (100; 500; 600) gemäß Anspruch 7,
bei dem ein umgekehrt proportionaler Zusammenhang zwischen der Stromaufnahme (I_{VZTS-VZE}) der Verzögerungsteilschaltung (310; 312, 314, 316, 318) des Verzögerungselementes (210) und der Verzögerungszeit (T_{VZE}) des Verzögerungselementes (210) besteht.

9. Oszillator (100; 500; 600) gemäß Anspruch 7 oder 8,
bei dem das zumindest eine Verzögerungselement (210) die zumindest eine Stromquellenteilschaltung (340; 342, 344) umfasst;
wobei die Stromquellenteilschaltung (340; 342, 344) ausgelegt ist, um die Stromaufnahme (I_{VZTS-VZE}) der Verzögerungsteilschaltung (310; 312, 314, 316, 318) des Verzögerungselementes (210) abhängig von einer Regelgröße (144, 350) anzupassen,
wobei die Stromquellenteilschaltung (340; 342, 344) einen ersten Transistor (342) und einen zweiten Transistor (344) umfasst;
wobei die Verzögerungsteilschaltung (310; 312, 314, 316, 318) einen dritten Transistor (312), einen vierten Transistor (314), einen fünften Transistor (316) und einen sechsten Transistor (318) umfasst,
wobei der vierte Transistor (314) und der fünfte Transistor (316) verbunden sind, um einen Inverter (320; 314, 316) der Verzögerungsteilschaltung (310; 312, 314, 316, 318) des Verzögerungselementes (210) zu bilden;
wobei der erste Transistor (342) ausgebildet ist, um abhängig von der Regelgröße (144, 350) einen Arbeitspunktstrom (I_{Bias}) einzustellen;
wobei der sechste Transistor (318) ausgebildet ist, um einen zweiten Strom (I₂) bereitzustellen,
wobei der zweite Transistor (344) mit dem dritten Transistor (312) verbunden ist, um einen Stromspiegel zu bilden, um einen durch den dritten Transistor (312) gelieferten Strom auf einen Wert zu begrenzen, der zu dem Wert des vom ersten Transistor (342) gelieferten Arbeitspunktstroms (I_{Bias}) proportional ist;
wobei der dritte Transistor (312) an den vierten Transistor (314) angeschlossen ist, so dass der durch den zweiten Transistor (344) und den dritten Transistor (312) gebildete Stromspiegel einen maximalen Laststreckenstrom des vierten Transistors (314) begrenzt; und
wobei der sechste Transistor (318) an den fünften Transistor (316) angeschlossen ist, so dass der sechste Transistor (318) einen maximalen Laststreckenstrom des fünften Transistors (316) auf einen zu dem Wert des Arbeitspunktstromes (I_{Bias}) proportionalen Stromwert begrenzt.

10. Oszillator (100; 500) gemäß einem der Ansprüche 1 bis 9,
bei dem die Regelschleife (140, 144, 150, 142; 540, 349, 350, 210a-210e, 313) ausgebildet ist, um das Frequenzsteuersignal (120) des Oszillators (100; 500) mit der Stromaufnahme (I_{VZTS-VZE}) der mindestens einen frequenzbestimmenden Teilschaltung (150; 312, 314, 316, 318) der Umladeoszillatorschaltung (130; 210a-210e) zu vergleichen und aus dem Vergleich des Frequenzsteuersignals (120) des Oszillators mit der Stromaufnahme (I_{VZTS-VZE}) der mindestens einen frequenzbestimmenden Teilschaltung (150; 312, 314, 316, 318) der Umladeoszillatorschaltung (130; 210a-210e) eine Regelgröße (350) zu bilden, um die Stromaufnahme (I_{VZTS-VZE}) der mindestens einen frequenzbestimmenden Teilschaltung (150; 312, 314, 316, 318) der Umladeoszillatorschaltung (130; 210a-210e) dem Frequenzsteuersignal (120) nachzuführen.

11. Oszillator (100; 600) gemäß einem der Ansprüche 1 bis 9,
bei dem der geregelte Versorgungszweig (610) des Oszillators (100; 600) einen stromgesteuerten Versorgungszweig (610) umfasst, der mit der zumindest einen frequenzbestimmenden Teilschaltung (150; 312, 314, 316, 318) gekoppelt ist, um die zumindest eine frequenzbestimmende Teilschaltung (150; 312, 314, 316, 318) mit einer Versorgungsspannung zu versorgen; und
wobei die Regelschleife (140, 144, 150, 142; 640, 350, 349, 210a-210e, 313) ausgebildet ist, um die an dem stromgesteuerten Versorgungszweig (610) anliegende Versorgungsspannung mit einer Referenzspannung (620) zu vergleichen;
wobei der Oszillator (100; 600) eine steuerbare Stromquelle (630) umfasst, die ausgelegt ist, um in Abhängigkeit von dem Frequenzsteuersignal (120) des Oszillators (100; 600) einen einstellbaren Strom in den stromgesteuerten Versorgungszweig (610) einzuprägen; und
wobei die Regelschleife (140, 144, 150, 142; 640, 650, 349, 210a-210e, 313) ausgebildet ist, um die Stromaufnahme (I_{VZTS-VZE}) der zumindest einen frequenzbestimmenden Teilschaltung (150; 312, 314, 316, 318) basierend auf dem Vergleich der an dem stromgesteuerten Versorgungsweg (610) anliegenden Versorgungsspannung mit der Referenzspannung (620) anzupassen, so dass die an dem stromgesteuerten Versorgungszweig (610) anliegende Versorgungsspannung bei Veränderung des Frequenzsteuersignals (120) und einer daraus resultierenden Veränderung des in den stromgesteuerten Versorgungszweig (610) eingeprägten Stroms konstant bleibt.

12. Oszillator (100; 500; 600) gemäß einem der Ansprüche 1 bis 11,
bei dem die Umladeoszillatorschaltung (130; 210a-210e) eine Mehrzahl von Verzögerungselementen (210; 210a-210e) umfasst, wobei die Verzögerungselemente (210; 210a-210e) differentielle Eingänge und differentielle Ausgänge aufweisen.

13. Oszillator (100; 500; 600) gemäß einem der Ansprüche 1 bis 12,
bei dem die Umladeoszillatorschaltung (130; 210a-210e) eine Mehrzahl von Verzögerungselementen (210; 210a-210e) umfasst,
wobei die Mehrzahl der Verzögerungselemente (210; 210a-210e) eine Mehrzahl von Transistoren (342, 344, 312, 314, 316, 318) und eine Arbeitspunktteilschaltung umfassen, um die Mehrzahl von Transistoren (342, 344, 312, 314, 316, 318) in ihrem Arbeitspunkt zu betreiben; und
wobei die Regelschleife (140, 144, 150, 142; 540, 640, 650, 349, 210a-210e, 313) ausgeprägt ist, um bei einer Regelung eine Stromaufnahme der Arbeitspunktteilschaltung der Mehrzahl von Transistoren (342, 344, 312, 314, 316, 318) unberücksichtigt zu lassen.

14. Oszillator (100; 500; 600) gemäß einem der Ansprüche 1 bis 13,
bei dem die Regelschleife (140, 144, 150, 142; 540, 640, 350, 349, 210a-210e, 313) eine Mehrzahl von Teilregelschleifen umfasst; und
wobei jeder Teilregelschleife mindestens ein Verzögerungselement der Umladeoszillatorschaltung (130; 210a-210e) zugeordnet ist.

## Claims

1. Oscillator (100; 500; 600) for generating electric oscillations (110) in dependence on a frequency control signal (120), the oscillator (100) comprising:
a charge-transfer oscillator circuit (130; 210a-210e) for generating the electric oscillations (110) while using at least one current source subcircuit (340, 342, 344) and at least one frequency-determining subcircuit (150; 312, 314, 316, 318);
a regulation loop (140, 144, 150, 142; 540, 640, 350, 349, 210a-210e, 313) configured to control the charge-transfer oscillator circuit (130; 210a-210e) such that the current consumption of the frequency-determining subcircuit (150; 312, 314, 316, 318) of the charge-transfer oscillator circuit (130; 210a-210e) adopts a value predefined by the frequency control signal (120); and
a regulated supply branch (510; 610) wherein the regulation loop (140, 144, 150, 142; 540, 640, 350, 349, 210a-210e, 313) is connected between a control input (349) of the charge-transfer oscillator circuit (130; 210a-210e) and a regulated supply current input (313) of the frequency-determining subcircuit 150; 312, 314, 316, 318).

2. Oscillator (100; 500; 600) as claimed in claim 1, further comprising unregulated supply branch (520, 660) configured to supply the at least one current source subcircuit (340, 342, 344) with a supply voltage.

3. Oscillator (100; 500; 600) as claimed in claim 1 or 2,
wherein the charge-transfer oscillator circuit (130; 210a-210e) is configured as a ring oscillator circuit (200);
said ring oscillator circuit (200) comprising at least one delay element (210; 210a-210e); and
the at least one delay element (210; 210a-210e) being configured to receive an input signal (220, 360) and to provide an output signal (240; 330) which is based on the input signal (220, 360) and wherein edges are delayed in time in relation to associated edges of the input signal (240, 330).

4. Oscillator (100; 500; 600) as claimed in claim 3,
wherein the ring oscillator circuit (200; 210a-210e) includes a plurality of delay elements (210; 210a, 210a-210e),
the plurality of delay elements (210; 210a-210e) being connected such that they form a ring and that a signal at an input of a predetermined delay element (210c) of the delay elements (210; 210a, 210b, 210c, 210d, 210e) is inverted, following a complete pass through the ring, as compared to a previous state;
wherein the ring oscillator circuit (200) is configured such that an output signal (110) of the ring oscillator circuit (200) is based on the output signal (329) of a delay element (210; 210c) of the delay elements (210; 210a-210e).

5. Oscillator (100; 500; 600) as claimed in one of claims 3 or 4,
wherein the at least one frequency-determining subcircuit (150; 312, 314, 316, 318) includes a delay subcircuit (310; 312, 314, 316, 318) of the at least one delay element (210);
the delay subcircuit (310) of the delay element (210) being configured such that there is a connection between the current consumption (I_{VZTS-VZE}) of the delay subcircuit (310; 312, 314, 316, 318) of the delay element (210) and a delay time (T_{VZE}) generated by the delay subcircuit (310; 312, 314, 316, 318) of the delay element (210);
the ring oscillator circuit (200) being configured such that the delay time (T_{VZE}) generated by the delay subcircuit (310; 312, 314, 316, 318) of the delay element (210) is inversely proportional to a frequency (f_{OSZ}) of the electric oscillations (110) generated by the oscillator (100; 500; 600).

6. Oscillator (100; 500; 600) as claimed in claim 5,
wherein the delay subcircuit (310; 312, 314, 316, 318) of the at least one delay element (210) includes an inverter (320; 314, 316) having an adjustable maximum output current, said inverter (320; 314, 316) being configured to invert the input signal (360) of the delay element (210), and the maximum output current of the inverter (320; 314, 316) influencing the frequency-determining subcircuit (150; 312, 314, 316, 318).

7. Oscillator (100; 500; 600) as claimed in one of claims 5 or 6,
wherein the at least one delay element (210) is realized in CMOS technology;
an output of a predefined delay element (210; 210a) being coupled to an input of a delay element (210; 210b) which ensues within an oscillator ring of the ring oscillator circuit (200) so as to transfer the charge of an input capacitance of the ensuing delay element (210b) while using the delay subcircuit (310; 312, 314, 316, 318) of the predefined delay element (210; 210a),
so that a delay time in the propagation of a signal edge to the ensuing delay element (210; 210b) is influenced by a charge-transfer time of the input capacitance of the ensuing delay element (210; 210b); and
the predefined delay element (210; 210a) being configured such that the current provided for transferring the charge of the input capacitance of the ensuing delay element (210; 210b) has a predefined relationship with the current consumption of the delay subcircuit (310; 312, 314, 316, 318) of the predefined delay element (210; 210a).

8. Oscillator (100; 500; 600) as claimed in claim 7,
wherein there is an inversely proportional relationship between the current consumption (I_{VZTS-VZE}) of the delay subcircuit (310; 312, 314, 316, 318) of the delay element (210) and the delay time (t_{VZE}) of the delay element (210).

9. Oscillator (100; 500; 600) as claimed in claim 7 or 8,
wherein the at least one delay element (210) includes the at least one current source subcircuit (340; 342, 344);
the current source subcircuit (340; 342, 344) being configured to adapt the current consumption (I_{VZTS-VZE}) of the delay subcircuit (310; 312, 314, 316, 318) of the delay element (210) as a function of a controlled variable (144, 350),
the current source subcircuit (340; 342, 344) including a first transistor (342) and a second transistor (344);
the delay subcircuit (310; 312, 314, 316, 318) including a third transistor (312), a fourth transistor (314), a fifth transistor (316), and a sixth transistor (318),
the fourth transistor (314) and the fifth transistor (316) being connected to form an inverter (320; 314, 316) of the delay subcircuit (310; 312, 314, 316, 318) of the delay element (210);
the first transistor (342) being configured to adjust an operating point current (I_{Bias}) as a function of the controlled variable (144, 350);
the sixth transistor (318) being configured to provide a second current (I₂),
the second transistor (344) being connected to the third transistor (312) to form a current mirror in order to limit a current provided by the third transistor (312) to a value that is proportional to the value of the operating point current (I_{Bias}) provided by the first transistor (342);
the third transistor (312) being connected to the fourth transistor (314) so that the current mirror formed by the second transistor (344) and the third transistor (312) limits a maximum load path current of the fourth transistor (314); and
the sixth transistor (318) being connected to the fifth transistor (316) so that the sixth transistor (318) limits a maximum load path current of the fifth transistor (316) to a current value proportional to the value of the operating point current (I_{Bias}).

10. Oscillator (100; 500) as claimed in any of claims 1 to 9,
wherein the regulation loop (140, 144, 150, 142; 540, 349, 350, 210a-210e, 313) is configured to compare the frequency control signal (120) of the oscillator (100; 500) with the current consumption (I_{VZTS-VZE}) of the at least one frequency-determining subcircuit (150; 312, 314, 316, 318) of the charge-transfer oscillator circuit (130;
210a-210e) and to form, from the comparison of the frequency control signal (120) of the oscillator with the current consumption (I_{VZTS-VZE}) of the at least one frequency-determining subcircuit (150; 312, 314, 316, 318) of the charge-transfer oscillator circuit (130; 210a-210e), a controlled variable (350) so as to control the current consumption (I_{VZTS-VZE}) of the at least one frequency-determining subcircuit (150; 312, 314, 316, 318) of the charge-transfer oscillator circuit (130; 210a-210e) to follow the frequency control signal (120).

11. Oscillator (100; 600) as claimed in any of claims 1 to 9,
wherein the regulated supply branch (610) of the oscillator (100; 600) includes a current-controlled supply branch (610) coupled to the at least one frequency-determining subcircuit (150; 312, 314, 316, 318) to supply the at least one frequency-determining subcircuit (150; 312, 314, 316, 318) with a supply voltage; and
the regulation loop (140, 144, 150, 142; 640, 350, 349, 210a-210e, 313) being configured to compare the supply voltage present at the current-controlled supply branch (610) with a reference voltage (620);
the oscillator (100; 600) including a controllable current source (610) configured to impress an adjustable current upon the current-controlled supply branch (610) as a function of the frequency control signal (120) of the oscillator (100; 600); and
the regulation loop (140, 144, 150, 142; 640, 650, 349, 210a-210e, 313) being configured to adapt the current consumption (I_{VZTS}-_{VZE}) of the at least one frequency-determining subcircuit (150; 312, 314, 316, 318) on the basis of the comparison of the supply voltage present at the current-controlled supply branch (610) with the reference voltage (620) so that the supply voltage present at the current-controlled supply branch (610) will remain constant in the event of a change in the frequency control signal (120) and upon a consequent change in the current impressed upon the current-controlled supply branch (610).

12. Oscillator (100; 500; 600) as claimed in any of claims 1 to 11,
wherein the charge-transfer oscillator circuit (130; 210a-210e) includes a plurality of delay elements (210; 210a-210e), said delay elements (210; 210a-210e) comprising differential inputs and differential outputs.

13. Oscillator (100; 500; 600) as claimed in any of claims 1 to 12,
wherein the charge-transfer oscillator circuit (130; 210a-210e) includes a plurality of delay elements (210; 210a-210e),
the plurality of delay elements (210; 210a-210e) including a plurality of transistors (342, 344, 312, 314, 316, 318) and an operating point subcircuit to operate the plurality of transistors (342, 344, 312, 314, 316, 318) in their operating points; and
the regulation loop (140, 144, 150, 142; 540, 640, 650, 349, 210a-210e, 313) being implemented to disregard a current consumption of the operating point subcircuit of the plurality of transistors (342, 344, 312, 314, 316, 318) during regulation.

14. Oscillator (100; 500; 600) as claimed in any of claims 1 to 13,
wherein the regulation loop (140, 144, 150, 142; 540, 640, 350, 349, 210a-210e, 313) includes a plurality of partial regulation loops; and
each partial regulation loop having at least one delay element of the charge-transfer oscillator circuit (130; 210a-210e) associated with it.

## Revendications

1. Oscillateur (100; 500; 600) pour générer des oscillations électriques (110) en fonction d'un signal de réglage de fréquence (120), l'oscillateur (100) présentant les caractéristiques suivantes:
un circuit oscillateur de transfert de charge (130; 210a à 210e) destiné à générer les oscillations électriques (110) avec au moins un circuit partiel de source de courant (340, 342, 344) et au moins un circuit partiel de détermination de fréquence (150; 312, 314, 316, 318);
une boucle de réglage (140, 144, 150, 142; 540, 640, 350, 349, 210a à 210e, 313), qui est conçu pour activer le circuit oscillateur de transfert de charge (130; 210a à 210e) de sorte que le courant absorbé du circuit partiel de détermination de fréquence (150; 312, 314, 316, 318) du circuit oscillateur de transfert de charge (130; 210a à 210e) adopte une valeur prédéterminée par le signal de réglage de fréquence (120); et
un branchement d'alimentation réglée (510; 610) dans lequel est connectée la boucle de réglage (140, 144, 150, 142; 540, 640, 350, 349, 210a à 210e, 313) entre une entrée de réglage (349) du circuit oscillateur de transfert de charge (130; 210a à 210e) et une entrée de courant d'alimentation réglée (313) du circuit partiel de détermination de fréquence (150; 312, 314, 316, 318).

2. Oscillateur (100; 500; 600) selon la revendication 1, présentant par ailleurs un branchement d'alimentation non réglée (520, 660) qui est réalisé pour alimenter l'au moins un circuit partiel de source de courant (340, 342, 344) en une tension d'alimentation.

3. Oscillateur (100; 500; 600) selon la revendication 1 ou 2,
dans lequel le circuit oscillateur de transfert de charge (130; 210a à 210e) est réalisé sous forme de circuit oscillateur annulaire (200);
dans lequel le circuit oscillateur annulaire (200) comporte au moins un élément de temporisation (210; 210a à 210e); et
dans lequel l'au moins un élément de temporisation (210; 210a à 210e) est réalisé pour recevoir un signal d'entrée (220, 360) et pour mettre à disposition un signal de sortie (240; 330) sur base du signal d'entrée (220, 360) et dans lequel les flancs sont retardés dans le temps par rapport aux flancs correspondants du signal d'entrée (240, 330).

4. Oscillateur (100; 500; 600) selon la revendication 3,
dans lequel le circuit oscillateur annulaire (200; 210a à 210e) comprend une pluralité d'éléments de temporisation (210; 210a, 210a à 210e),
dans lequel la pluralité d'éléments de temporisation (210; 210a à 210e) sont connectés de sorte qu'ils forment un anneau et qu'un signal à une entrée d'un élément de temporisation prédéterminé (210c) parmi les éléments de temporisation (210; 210a, 210b, 210c, 210d, 210e) soit, après un passage complet dans l'anneau, inversé par rapport à l'état précédent;
dans lequel le circuit oscillateur annulaire (200) est réalisé de sorte qu'un signal de sortie (110) du circuit oscillateur annulaire (200) se base sur le signal de sortie (329) d'un élément de temporisation (210; 210c) parmi les éléments de temporisation (210; 210a à 210e).

5. Oscillateur (100; 500; 600) selon l'une des revendications 3 ou 4,
dans lequel l'au moins un circuit partiel de détermination de fréquence (150; 312, 314, 316, 318) comprend un circuit partiel de temporisation (310; 312, 314, 316, 318) de l'au moins un élément de temporisation (210);
dans lequel le circuit partiel de temporisation (310) de l'élément de temporisation (210) est conçu de sorte qu'il existe un rapport entre le courant absorbé (I_{VZTS-VZE}) du circuit partiel de temporisation (310; 312, 314, 316, 318) de l'élément de temporisation (210) et un temps de retard (t_{VZE}) généré par le circuit partiel de temporisation (310; 312, 314, 316, 318) de l'élément de temporisation (210);
dans lequel le circuit oscillateur annulaire (200) est conçu de sorte que le temps de retard (T_{VZE}) généré par le circuit partiel de temporisation (310; 312, 314, 316, 318) de l'élément de temporisation (210) soit inversement proportionnel à une fréquence (f_{OSZ}) des oscillations électriques (110) générées par l'oscillateur (100; 500; 600).

6. Oscillateur (100; 500; 600) selon la revendication 5,
dans lequel le circuit partiel de temporisation (310; 312, 314, 316, 318) de l'au moins un élément de temporisation (210) comprend un inverseur (320; 314, 316) à courant de sortie maximum réglable, l'inverseur (320; 314, 316) étant conçu pour inverser le signal d'entrée (360) de l'élément de temporisation (210) et le courant de sortie maximum de l'inverseur (320; 314, 316) influençant le circuit partiel de détermination de fréquence (150; 312, 314, 316, 318).

7. Oscillateur (100; 500; 600) selon l'une des revendications 5 ou 6,
dans lequel au moins un élément de temporisation (210) est réalisé en technologie CMOS;
dans lequel une sortie d'un élément de temporisation prédéterminé (210; 210a) est couplée à une entrée d'un élément de temporisation (210; 210a) suivant dans un anneau d'oscillateur du circuit oscillateur annulaire (200), pour transférer une capacité d'entrée de l'élément de temporisation suivant (210b) à l'aide du circuit partiel de temporisation (310; 312, 314, 316, 318) de l'élément de temporisation prédéterminé (210; 210a),
de sorte qu'un temps de retard lors de la diffusion d'un flanc de signal vers l'élément de temporisation suivant (210; 210b) soit influencé par un temps de transfert de la capacité d'entrée de l'élément de temporisation suivant (210; 210b); et
dans lequel l'élément de temporisation prédéterminé (210; 210a) est conçu de sorte que le courant mis à disposition pour le transfert de la capacité d'entrée de l'élément de temporisation suivant (210; 210b) présente un rapport déterminé avec le courant absorbé du circuit partiel de temporisation (310; 312, 314, 316, 318) de l'élément de temporisation prédéterminé (210; 210a).

8. Oscillateur (100; 500; 600) selon la revendication 7,
dans lequel il existe un rapport inversement proportionnel entre le courant absorbé (I_{VZTS-VZE}) du circuit partiel de temporisation (310; 312, 314, 316, 318) de l'élément de temporisation (210) et le temps de retard (T_{VZE}) de l'élément de temporisation (210).

9. Oscillateur (100; 500; 600) selon la revendication 7 ou 8,
dans lequel l'au moins un élément de temporisation (210) comprend l'au moins un circuit partiel de source de courant (340; 342, 344);
le circuit partiel de source de courant (340; 342, 344) étant conçu pour adapter le courant absorbé (I_{VZTS-VZE}) du circuit partiel de temporisation (310; 312, 314, 316, 318) de l'élément de temporisation (210) en fonction d'une grandeur de réglage (144, 350),
le circuit partiel de source de courant (340; 342, 344) comportant un premier transistor (342) et un deuxième transistor (344);
le circuit partiel de temporisation (310; 312, 314, 316, 318) comportant un troisième transistor (312), un quatrième transistor (314), un cinquième transistor (316) et un sixième transistor (318),
le quatrième transistor (314) et le cinquième transistor (316) étant reliés entre eux, pour former un inverseur (320; 314, 316) du circuit partiel de temporisation (310; 312, 314, 316, 318) de l'élément de temporisation (210);
le premier transistor (342) étant réalisé pour régler, en fonction de la grandeur de réglage (144, 350), un courant de point de travail (I_{Bias});
le sixième transistor (318) étant réalisé pour mettre à disposition un deuxième courant (I₂),
le deuxième transistor (344) étant relié au troisième transistor (312), pour former un miroir de courant, pour limiter un courant fourni par le troisième transistor (312) à une valeur qui est proportionnelle à la valeur du courant de point de travail (I_{Bias}) fourni par le premier transistor (342);
le troisième transistor (312) étant raccordé au quatrième transistor (314), de sorte que le miroir de courant formé par le deuxième transistor (344) et le troisième transistor (312) limite un courant de trajet de charge maximum du quatrième transistor (314); et
le sixième transistor (318) étant raccordé au cinquième transistor (316), de sorte que le sixième transistor (318) limite un courant de trajet de charge maximum du cinquième transistor (316) à une valeur de courant proportionnelle à la valeur du courant de point de travail (I_{Bias}).

10. Oscillateur (100; 500) selon l'une des revendications 1 à 9,
dans lequel la boucle de réglage (140, 144, 150, 142; 540, 349, 350, 210a à 210e, 313) est réalisée pour comparer le signal de réglage de fréquence (120) de l'oscillateur (100; 500) au courant absorbé (I_{VZTS-VZE}) de l'au moins un circuit partiel de détermination de fréquence (150; 312, 314, 316, 318) du circuit oscillateur de transfert de charge (130; 210a à 210e) et pour former, à partir de la comparaison du signal de réglage de fréquence (120) de l'oscillateur avec le courant absorbé (I_{VZTS-VZE}) de l'au moins un circuit partiel de détermination de fréquence (150; 312, 314, 316, 318) du circuit oscillateur de transfert de charge (130; 210a à 210e), une grandeur de réglage (350), pour mettre à jour le courant absorbé (I_{VZTS-VZE}) de l'au moins un circuit partiel de détermination de fréquence (150; 312, 314, 316, 318) du circuit oscillateur de transfert de charge (130; 210a à 210e) dans le signal de réglage de fréquence (120).

11. Oscillateur (100; 600) selon l'une des revendications 1 à 9,
dans lequel le branchement d'alimentation réglée (610) de l'oscillateur (100; 600) comporte un branchement d'alimentation réglée par le courant (610) qui est couplé à l'au moins un circuit partiel de détermination de fréquence (150; 312, 314, 316, 318), pour alimenter l'au moins un circuit partiel de détermination de fréquence (150; 312, 314, 316, 318) en une tension d'alimentation; et
dans lequel la boucle de réglage (140, 144, 150, 142; 640, 350, 349, 210a à 210e, 313) est réalisée pour comparer la tension d'alimentation présente au branchement d'alimentation réglée par le courant (610) avec une tension de référence (620);
l'oscillateur (100; 600) comportant une source de courant réglable (630) qui est conçue pour imprimer, en fonction du signal de réglage de fréquence (120) de l'oscillateur (100; 600), un courant réglable dans le branchement d'alimentation réglée par le courant (610); et
la boucle de réglage (140, 144, 150, 142; 640, 650, 349, 210a à 210e, 313) étant réalisée pour adapter le courant absorbé (I_{VZTS-VZE}) de l'au moins un circuit partiel de détermination de fréquence (150; 312, 314, 316, 318) sur base de la comparaison de la tension d'alimentation présente au branchement d'alimentation réglée par le courant (610) avec la tension de référence (620), de sorte que la tension d'alimentation présente au branchement d'alimentation réglée par le courant (610) reste constante en cas de variation du signal de réglage de fréquence (120) et de variation en résultant du courant imprimé dans le branchement d'alimentation réglée par le courant (610).

12. Oscillateur (100; 500; 600) selon l'une des revendications 1 à 11,
dans lequel le circuit oscillateur de transfert de charge (130; 210a à 210e) comporte une pluralité d'éléments de temporisation (210; 210a à 210e), les éléments de temporisation (210; 210a à 210e) présentent des entrées différentielles et des sorties différentielles.

13. Oscillateur (100; 500; 600) selon l'une des revendications 1 à 12,
dans lequel le circuit oscillateur de transfert de charge (130; 210a à 210e) comporte une pluralité d'éléments de temporisation (210; 210a à 210e),
la pluralité d'éléments de temporisation (210; 210a à 210e) comportant une pluralité de transistors (342, 344, 312, 314, 316, 318) et un circuit partiel de point de travail, pour faire fonctionner la pluralité de transistors (342, 344, 312, 314, 316, 318) à leur point de travail; et
la boucle de réglage (140, 144, 150, 142; 540, 640, 650, 349, 210a à 210e, 313) étant conçue pour, lors d'un réglage, ne pas tenir compte d'un courant absorbé du circuit partiel de point de travail de la pluralité de transistors (342, 344, 312, 314, 316, 318).

14. Oscillateur (100; 500; 600) selon l'une des revendications 1 à 13,
dans lequel la boucle de réglage (140, 144, 150, 142; 540, 640, 350, 349, 210a à 210e, 313) comporte une pluralité de boucles de réglage partielles; et
à chaque boucle de réglage partielle étant associé au moins un élément de temporisation du circuit oscillateur de transfert de charge (130; 210a à 210e).
